# DEMANDE DE BREVET EUROPEEN

(11) **EP 0 937 691 A1**
(43) Date de publication de la demande: **25.08.1999**
(21) Numéro de dépôt: 99400427.3
(22) Date de dépôt: 22.02.1999
(51) Int. Cl.: C03C 23/00, C09D 11/00, C03C 15/00

(54) **Procédé de gravure d'une couche conductrice**

(30) Priorité: 23.02.1998 FR 9802138
(71) Demandeur: SAINT-GOBAIN VITRAGE, 92400 Courbevoie (FR)
(72) Inventeur: Rouberol, Marc, Hoboken, NJ 07030 (US)
(74) Mandataire: Renous Chan, Véronique

(57) **Abrégé**

L'invention a pour objet un procédé de gravure chimique d'une couche (2) à propriétés de conduction électrique sur un substrat transparent (1) de type verrier.

Il comporte au moins une étape de dépôt d'un masque (3) comprenant au moins une encre thermofusible sur la couche à graver.

## Description

L'invention concerne un procédé de gravure de couches, déposées sur des substrats transparents du type substrat verrier, et plus particulièrement des couches au moins légèrement conductrices électriquement en vue d'obtenir des électrodes, éléments conducteurs.

L'invention s'intéresse notamment aux couches à base d'oxyde métallique dopé ou à base de métal, et de préférence celles qui par leurs caractéristiques propres et leurs épaisseurs sont transparentes. Elle n'exclut cependant pas les couches opaques.

Beaucoup de produits à base de substrats verriers ont en effet besoin d'éléments conducteurs selon des motifs particuliers, avec une bonne, voire une très haute résolution. C'est par exemple le cas des électrodes des verres d'écrans émissifs du type écran plat, des électrodes des cellules photovoltaïques ou encore des réseaux d'éléments conducteurs des vitrages chauffants ou incorporant des antennes.

Il est connu du brevet US-3 837 944 une technique de gravure chimique de couches d'oxyde métallique conducteur, consistant tout d'abord à déposer sur la couche à graver une couche continue à base de résine dite « photoresist » qu'il faut insoler à travers un cliché, développer puis rincer de façon à obtenir un masque ayant le motif voulu. Ensuite, est opérée une attaque chimique des zones de la couche non recouvertes par la résine.

On voit que par cette technique, l'obtention du masque est complexe et nécessite un certain nombre d'étapes. En outre, elle est mal adaptée aux petites séries, puisqu'il faut pour chaque motif créer un nouveau cliché, et aux substrats de grandes dimensions.

L'invention a alors pour but de remédier à ces inconvénients, notamment en proposant un nouveau type de gravure chimique qui soit plus performant, notamment plus souple de mise en oeuvre, plus simple, plus rapide.

L'invention a pour objet un procédé de gravure chimique d'une couche à propriétés de conduction électrique, de type oxyde métallique dopé ou métal, sur un substrat transparent de type verrier, et qui comporte au moins une étape de dépôt d'un masque comprenant au moins une encre thermofusible sur la couche à graver.

Au sens de l'invention, on comprend par « à propriétés de conduction électrique », des couches présentant une résistivité d'au plus 4.10⁻²Ω.cm, notamment d'environ 4.10⁻³ à 4.10⁻⁴Ω.cm au moins. Sont visées plus particulièrement les couches d'au plus 1000 Ω/carré et de préférence d'au plus 500 Ω/carré, pour des épaisseurs de couche généralement comprises entre 100 et 300 nm.

La gravure de telles couches permet en effet d'obtenir des réseaux d'électrodes d'applications variées. Cependant, il va de soi que la technique de gravure de l'invention peut tout aussi bien s'appliquer à des couches peu ou pas conductrices du tout, du type diélectrique, oxyde métallique non dopé par exemple, s'il y a un intérêt à les graver, notamment dans un but décoratif.

Avoir recours à un masque à base d'encre thermofusible, par exemple déposée par une technique d'impression par jet d'encre, est extrêmement avantageux pour différentes raisons : tout d'abord, on peut directement déposer le masque selon le motif désiré, en une seule étape, ce qui est beaucoup plus rapide que la technique de dépôt décrite plus haut impliquant au moins trois étapes pour obtenir le masque voulu. Ensuite, ce masque est très adapté aux petites séries : il n'est pas nécessaire de stocker des quantités de clichés. En fait il suffit, pour chaque nouveau motif, de reprogrammer la machine de dépôt qui est avantageusement pilotée par des moyens électroniques/informatiques et de simplement lui faire mémoriser les motifs. En dernier lieu, il est relativement aisé de déposer ce type de masque sur des substrats de grandes dimensions.

Il était cependant loin d'être sûr que déposer le masque par impression d'encre thermofusible donnerait des résultats probants. En effet, ce type d'encre était jusque-là utilisé pour une toute autre application, à savoir le marquage définitif d'objet. Dans le contexte d'une gravure chimique, il fallait d'une part que ces encres puissent résister à une attaque corrosive chimique très agressive, et d'autre part qu'on puisse, après gravure, les retirer aisément, exigences absolument pas requises ou recherchées dans une application de marquage d'objets standards.

Or, de manière tout à fait surprenante, il s'est avéré que les encres thermofusibles, si elles étaient sélectionnées de façon appropriée, remplissaient tous ces objectifs.

L'épaisseur du masque que l'on dépose peut varier selon différents critères, elle peut par exemple être de 20 à 60 µm.

Avantageusement, ces encres comprennent une ou plusieurs cires essentiellement organiques. Le terme « cire » est connu dans le domaine de l'impression par jet d'encre, il comprend généralement des polymères à longue chaîne du type polymères carbonés aliphatiques. On peut citer plus particulièrement la famille des polyoléfines du type polypropylène, polyéthylène, ainsi que la paraffine, le polystyrène. Ces encres peuvent aussi comprendre un certain nombre d'additifs, du type plastifiant tel que l'éthylène vinylacétate EVA, des anti-oxydants ou des colorants.

L'avantage des encres sélectionnées selon l'invention est qu'elles présentent une température de fusion d'au moins 60°C. notamment d'au moins 75°C, de préférence comprise entre 75 et 100°C, ou 75 et 85°C : déposées à chaud en phase liquide sur la couche à graver, elles refroidissent extrêmement vite pour se solidifier sur la couche avec le motif voulu.

De préférence, elles sont choisies insolubles à l'eau, tout particulièrement si l'attaque chimique de la couche fait intervenir un solvant aqueux. De même, elles résistent avantageusement à une attaque par l'hydrogène naissant, qui peut être utilisé pour obtenir l'attaque chimique voulue de la couche dans les zones non recouvertes par le masque.

Le procédé de gravure selon l'invention se déroule de préférence selon les phases successives suivantes :
(a) - dépôt du masque comprenant au moins une encre thermofusible sur la couche à graver (directement selon le motif voulu),
(b) - attaque de la couche dans les zones dépourvues du masque par de l'hydrogène naissant (c'est-à-dire : soit on génère l'hydrogène naissant uniquement dans les zones sans masque, soit, plus simplement, on génère l'hydrogène naissant de façon non ou moins sélective, l'attaque se concentrant cependant sur les zones sans masque, les zones masquées se trouvant protégées de l'attaque corrosive par l'hydrogène),
(c) - optionnellement, traitement de nettoyage du substrat à couche (notamment pour évacuer l'excès des matériaux/solvants utilisés pour générer l'hydrogène naissant),
(d) - le retrait du masque.

Selon une première variante de l'invention, on génère l'hydrogène naissant en associant du zinc, notamment en poudre, avec un acide fort. L'opération se fait généralement en deux temps, à savoir la mise en contact des zones de la couche dépourvues du masque avec du zinc pulvérulent, puis avec une solution à pH acide, ou inversement.

Le zinc pulvérulent peut être projeté sur la couche en phase solide, à l'aide d'une buse de distribution de poudre connue.

On peut aussi projeter le zinc pulvérulent sur la couche en phase liquide, fluide ou en une émulsion du type aérogel, notamment en mettant la poudre de zinc en suspension dans un ou plusieurs solvants organiques, du type terpinéol et/ou aqueux, éventuellement munis d'additifs, tout particulièrement à fonction de modificateur de rhéologie tel que l'aérosil. Il est avantageux de sélectionner les solvants de façon à ce qu'ils soient compatibles, solubles dans la solution vecteur de l'acide fort, de façon à favoriser la réaction entre la poudre de zinc et l'acide. On peut projeter le zinc ainsi en suspension par différentes techniques, notamment par spray (à l'aide d'un dispositif apte à pulvériser en gouttelettes une solution), ou par sérigraphie.

On peut envisager aussi de mettre en contact la couche à graver avec le zinc en déposant sur la couche une fois masquée une fine couche de zinc, par exemple par une technique utilisant le vide du type pulvérisation cathodique.

En ce qui concerne la solution à pH acide, celle-ci peut comprendre au moins un solvant aqueux ou organique de type alcoolique, et de préférence être à base d'un mélange hydroalcoolique du type eau + éthanol ou isopropanol. Il s'est en effet avéré qu'ajouter de l'alcool à l'eau contenant l'acide permettait de mieux contrôler la taille des bulles d'hydrogène créées au contact du zinc, notamment de diminuer la taille de ces bulles pour faire une attaque plus « douce » de la couche (et éviter ainsi tout risque de décollement du masque soumis à l'action mécanique des bulles de H₂). En complément ou à la place de l'alcool, cet effet peut aussi être obtenu en ajoutant des additifs appropriés du type surfactant, anionique, cationique ou non-ionique.

L'acide choisi de préférence est un acide fort du type HCI. Avantageusement, on peut sélectionner un pourcentage massique d'acide de type HCI dans la solution de l'ordre de 1 à 20%, notamment de l'ordre de 1 à 10%, ce qui correspond à une concentration qui n'est pas extrêmement élevée, ce qui est bien pour éviter l'usure prématurée par corrosion des outillages en contact avec la solution, mais une concentration néanmoins suffisante pour obtenir la gravure voulue.

La mise en contact de la solution à pH acide avec la couche à graver peut se faire par exemple par une technique de spray ou par immersion du substrat dans un bain de la solution. Il peut ainsi être avantageux d'utiliser une technique de spray à la fois pour déposer la solution contenant le zinc et celle contenant l'acide, en termes de simplicité d'outillages et de compaction de la ligne de fabrication, le substrat pouvant ainsi défiler à la vitesse appropriée sous l'une puis sous l'autre buse de pulvérisation.

Selon une seconde variante de l'invention, on génère l'hydrogène naissant en mettant en contact les zones de la couche dépourvues du masque avec de l'aluminium, notamment pulvérulent, puis avec une solution à pH alcalin, ou inversement. La projection de l'aluminium pulvérulent peut se faire comme celle du zinc décrite plus haut. De même, on peut alternativement, mettre en contact la couche à graver avec l'aluminium en déposant une fine couche d'AI sur la couche une fois masquée, par une technique du type pulvérisation cathodique. Quant à la solution alcaline, on peut choisir le même type de solvant et le même type de technique de projection que pour la solution acide précédente, en utilisant cette fois une base plutôt qu'un acide, notamment une base forte du type NaOH.

La phase (c) du traitement de nettoyage peut simplement consister à rincer la couche, notamment afin d'évacuer les résidus de poudre métallique, d'acide ou de base. Cela peut se faire à l'aide d'un spray ou par immersion du substrat à l'aide d'une solution de nettoyage, à base d'eau et/ou de solvant organique.

Le retrait du masque peut se faire de différentes façons. De façon non limitative, on peut d'abord choisir une voie chimique, en le dissolvant dans un solvant approprié, notamment essentiellement organique. Cela peut être du toluène, de l'essence de térébenthine, du trichlorométhane ou de l'acétate de butyle.

Si on ne souhaite pas à avoir à retraiter d'effluents organiques, il vaut mieux privilégier d'autres voies : il peut s'agir d'un traitement par ultrasons, plutôt réservé cependant à des substrats de dimensions modestes. Il peut aussi s'agir d'un traitement thermique, en envoyant, par exemple sur le substrat en défilement une lame d'air chaud : la lame vient ramollir le masque qui devient liquide et est évacué par le souffle d'air. Une autre solution consiste à faire passer le substrat dans un four, par exemple à au moins 250°C, notamment à des températures de l'ordre de 400 à 450°C pour brûler le masque et le détruire. L'avantage d'un tel traitement à très haute température est qu'il peut en fait se faire concomitamment à un autre traitement thermique que doit subir par ailleurs le substrat ou l'un ou l'autre des revêtements dont il peut être muni, indépendamment du procédé de gravure. C'est notamment le cas généralement pour les substrats verriers utilisés dans l'électronique, par exemple pour ceux entrant dans la constitution d'écrans émissifs, où les verres doivent subir au moins un traitement thermique à haute température visant à les stabiliser dimensionnellement.

Une autre technique consiste à ramollir le masque par un traitement thermique à température modérée pour faciliter son décollement, puis à le peler, par traction mécanique.

Le procédé de gravure selon l'invention peut graver des couches très diverses, notamment des couches d'oxyde métallique dopé tel que l'oxyde d'étain dopé au fluor SnO₂:F, l'oxyde d'étain dopé à l'arsenic SnO₂:As, ou à l'antimoine SnO₂:Sb, ou avec d'autres métaux dopants de la colonne Va du tableau périodique. Il peut aussi graver des couches à base d'oxyde d'indium dopé à l'étain ITO, ou éventuellement des couches en métal, en argent par exemple. Ces couches peuvent être plus ou moins épaisses, par exemple de quelques nanomètres à quelques centaines de nanomètres. Il peut ainsi s'agir de couches de 20 à 500 nm, notamment d'au moins 40 nm, par exemple de 200 à 380 nm.

La nature de la couche et son épaisseur sont à prendre en compte pour ajuster les concentrations des solutions d'attaque corrosive, les temps de gravure (généralement de l'ordre d'au plus quelques minutes). Il s'est avéré que le procédé selon l'invention était particulièrement efficace pour graver des couches à base de SnO₂, notamment en SnO₂:F, jusque-là connues pour être au contraire très « dures », résistantes chimiquement, et donc difficiles à graver. Cela ouvre ainsi un champ d'applications beaucoup plus diversifié pour ce type de couche, tout particulièrement dans l'électronique pour faire des électrodes, à la place d'électrodes usuellement en ITO, performantes mais nécessitant généralement des traitements de recuit pour obtenir le niveau de conduction électrique requis.

L'invention a également pour objet l'application du procédé à la fabrication d'électrodes/éléments conducteurs dans différents domaines. Il peut s'agir de l'industrie verrière, par exemple en vue de fabriquer des réseaux conducteurs pour vitrage chauffant par effet Joule, ou des vitrages incorporant des antennes. Il peut s'agir aussi de l'industrie des cellules photovoltaïques. Enfin, il peut s'agir de l'industrie électronique, en vue de fabriquer des faces avant ou faces arrière d'écrans émissifs du type écran plat, écran dit écran plasma, ou encore des écrans tactiles, et plus généralement tout type d'écran/vitrage susceptible de recevoir, transmettre ou d'émettre des rayonnements, notamment de la lumière visible.

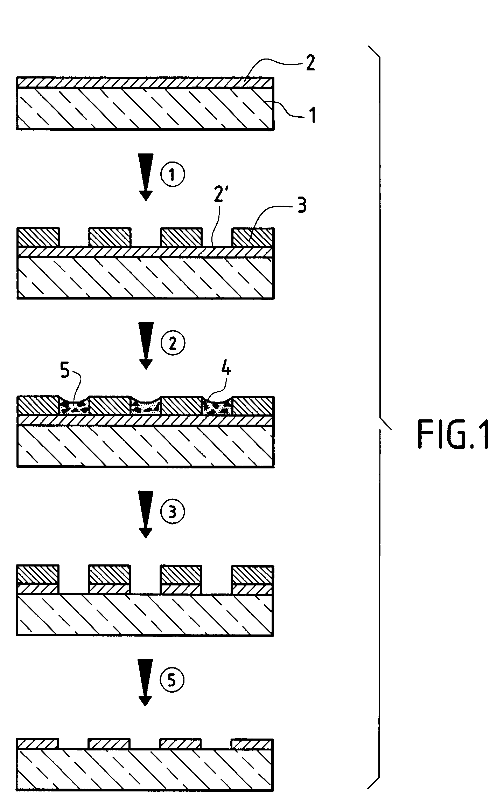

L'invention sera décrite ci-après plus en détails à l'aide d'exemples non limitatifs illustrés par la figure suivante :
□ **figure 1** : une représentation très schématique des étapes du procédé de gravure selon l'invention.

Dans toute la suite de la description détaillée, on convient que tous les substrats utilisés sont des substrats verriers flottés d'environ 2,8 mm d'épaisseur, en vue de constituer des faces avant et arrière d'écrans émissifs du type écran plasma, de composition chimique suivante, en proportions pondérales :

| | |
|---|---|
| SiO₂ | 58 % |
| Al₂O₃ | 3 % |
| ZrO₂ | 8 % |
| Na₂O | 4,5 % |
| K₂O | 7,5 % |
| CaO | 8,5 % |
| SrO | 9 % |
| BaO | 0 % |
| SO₃ | traces (0,07 à 0,1%) |

Cette composition conduit à une valeur de température inférieure de recuisson d'environ 609°C et une valeur de coefficient de dilatation thermique α_{(25-300°C)} d'environ 83,6.10⁻⁷°C⁻¹.

D'autres compositions de verre appropriées pour ce type d'application sont notamment décrites dans les brevets WO96/11887 et EP-98/400053.9 du 13 janvier 1997.

Une étape préalable, non décrite ici en détail car connue de l'homme de l'art, a consisté à déposer sur deux substrats verriers de dimensions 60 cm x 1000 cm, une couche de SnO₂:F de 270 nm, soit par une technique du type pyrolyse en phase gazeuse (appelée aussi CVD pour Chemical Vapor Deposition) directement en continu sur le ruban de verre float, soit en reprise sur les verres découpés. Le but est d'obtenir une gravure de haute résolution des couches pour former des électrodes sous forme de bandes parallèles de 1000 cm de long, de 125 µm de large. Ces bandes sont groupées en « paires » de bandes espacées les unes des autres de 175 µm, avec une distance entre deux bandes d'une même paire de 50 µm.

Les grandes étapes du procédé de gravure de l'invention sont représentées schématiquement à la figure 1 : on part du substrat verrier 1 découpé et façonné de façon appropriée, recouvert de la couche 2 de SnO₂:F,
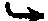 selon l'étape ①, on dépose directement au motif voulu par impression par jet d'encre une encre thermofusible de façon à former le masque 3, déposé sous forme de paire de bandes parallèles de 125 µm de large, distantes les unes des autres de 175 µm, avec une distance entre deux bandes d'une même paire égale à 50 µm, selon le motif voulu,
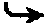 l'étape ② consiste à projeter à la surface de la couche 2 masquée de la poudre de Zn (ou d'Al), représentée grossièrement sous la référence 4 en suspension dans un fluide 5,
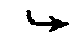 l'étape ③ consiste à projeter ensuite à la surface de la couche 2 masquée une solution à pH acide (ou basique si à l'étape précédente de la poudre d'AI et non de Zn a été projetée sur la couche) : il se forme de l'hydrogène naissant qui détruit la couche 2 dans ses zones 2' non masquées,
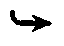 on rince ensuite le substrat (étape ④ non représentée),
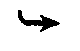 dans une étape ⑤, on retire le masque, de façon à obtenir une couche de SnO₂:F gravée selon un motif identique à celui du masque, à savoir des bandes au motif voulu.

Les exemples 1 à 3 suivants détaillent ces différentes étapes, selon plusieurs variantes. Dans tous ces exemples, l'encre thermofusible destinée à constituer le masque 3 est une encre commercialisée par la société Markem Corporation sous la référence 96206. Elle a une température de fusion aux alentours de 80°C, et sa composition comprend des cires de polyéthylène, polypropylène, polystyrène, de l'éthylène vinylacétate, un agent anti-oxydant et un agent colorant à base d'antraquinone. Elle est déposée sur les substrats par une imprimante à jet d'encre thermofusible fonctionnant sur le principe connu du jet d'encre « goutte à la demande » piézo-électrique, imprimante commercialisée par la société Markem Corporation sous la référence Markem 962 et programmable par des moyens informatiques.

### EXEMPLE 1

L'étape ① s'effectue à l'aide de l'encre et de son dispositif décrit plus haut. Le masque obtenu a une épaisseur d'environ 30 à 50 µm.

L'étape ② s'effectue à l'aide du mélange constitué par de la poudre de zinc (référence ZN006020 de la société Goodfellow) et de terpinéol (référence 432628 de la société Aldrich), dans des proportions de 3:1 en masse. Ce mélange a la consistance d'une huile relativement fluide. Il est déposé sur l'ensemble de la couche 2 par sérigraphie, à l'aide d'un écran de sérigraphie en polyester, de taille de mailles 90 et d'ouverture 63 µm. Le mélange se canalise alors dans les zones 2' non masquées de la couche 2.

L'étape ③ consiste à graver ces zones 2', en immergeant le substrat 1 dans un bain de solution de gravure constitué d'eau, d'isopropanol et d'acide chlorhydrique (rapport eau/isopropanol de 9/1 en volume, et concentration volumique de 6% d'HCI). L'immersion est maintenue 3 minutes.

L'étape ④ de rinçage se fait par immersion du substrat 1 dans un second bain constitué d'un mélange eau/éthanol.

L'étape ⑤ de retrait du masque 3 se fait par immersion du substrat 1 dans un troisième bain de trichlorométhane.

La couche de SnO₂:F obtenue après ces traitements est gravée selon le motif voulu avec une bonne résolution.

### EXEMPLE 2

L'étape ① s'effectue comme à l'exemple 1.

L'étape ② s'effectue à l'aide du mélange constitué de la même poudre de Zn que dans l'exemple 1, d'eau et d'aérosil servant de modificateur de rhéologie dans des proportions massiques respectives de 38%, 60,5% et 1,5%. Ce mélange a la consistance d'un aérogel. Il est déposé sur la totalité de la couche 2 par spray à l'aide d'un dispositif de pulvérisation standard.

L'étape ③ consiste à graver ces zones 2', en immergeant le substrat 1 dans un bain de solution de gravure constitué d'eau, d'isopropanol et d'acide chlorhydrique (rapport eau/isopropanol de 4/1 en volume, et concentration volumique d'HCl de 1,5%). L'immersion est maintenue 4 minutes.

L'étape ④ de rinçage se fait par immersion du substrat 1 dans un bain constitué d'eau.

L'étape ⑤ de retrait du masque est effectuée par un traitement thermique du substrat dans un four approprié à 450°C pendant 30 minutes.

La couche de SnO₂:F obtenue est gravée avec la même qualité que celle de l'exemple 1.

### EXEMPLE 3

L'étape ① s'effectue comme à l'exemple 1, sur une couche de SnO₂:F ici de 130 nm.

L'étape ② s'effectue à l'aide du mélange constitué par de la poudre d'aluminium (référence LS155124JV de la Société Goodfellow) et du terpinéol utilisé pour l'exemple 1, dans des proportions 5:3 en masse. Ce mélange est déposé sur la couche 2 par sérigraphie avec l'écran selon l'exemple 1 et de la même façon.

L'étape ③ consiste à graver les zones 2', en immergeant le substrat 1 dans un bain de solution de gravure constitué d'eau, d'éthanol et de soude NaOH dans une concentration 1 mole/litre à 50°C. L'immersion est maintenue 5 minutes.

L'étape ④ de rinçage se fait par immersion du substrat 1 dans un bain constitué d'eau et d'HNO3 68% volumique pendant quelques secondes, puis dans un troisième bain constitué d'eau et d'éthanol.

L'étape ⑤ de retrait du masque se fait comme à l'exemple 1.

La couche de SnO₂:F obtenue est telle qu'elle n'est plus conductrice dans les zones gravées.

En conclusion, le procédé de l'invention comprend peu d'étapes, notamment grâce à la façon dont on dépose le masque. On peut modifier très facilement le motif du masque en programmant de façon appropriée l'ordinateur pilotant l'imprimante à jet d'encre, et traiter des substrats de taille significative par exemple d'au moins 1 m x 1 m. La plupart des étapes peuvent se faire en continu, le substrat pouvant successivement défiler d'un bain à un autre, d'un dispositif de pulvérisation à un autre. Le traitement de retrait par chauffage comme dans l'exemple 2 peut s'intégrer dans une phase de traitement thermique du verre ou d'autres revêtements qu'il peut avoir.

On a pu vérifier que les encres thermofusibles à la base des masques résistaient parfaitement à des attaques par de l'hydrogène naissant, à des attaques acides aussi bien qu'à des attaques basiques. L'invention permet ainsi de graver efficacement des couches à base de SnO₂, jusque là difficiles à graver, et donc a fortiori beaucoup d'autres couches plus faciles à graver comme des couches d'ITO, ... .

## Revendications

1. Procédé de gravure chimique d'une couche (2) à propriétés de conduction électrique, de type oxyde métallique dopé, sur un substrat transparent (1) de type verrier, ***caractérisé en ce qu'il*** comporte au moins une étape de dépôt d'un masque (3) comprenant au moins une encre thermofusible sur la couche à graver.

2. Procédé selon la revendication 1, ***caractérisé en ce que*** la(les) encre(s) thermofusible(s) comprennent une ou plusieurs cires essentiellement organiques, notamment à base de polymères carbonés aliphatiques du type composés de la famille des polyoléfines, telles que la paraffine, le polyéthylène, le polypropylène et/ou du polystyrène.

3. Procédé selon l'une des revendications précédentes, ***caractérisé en ce que*** la(les) encre(s) thermofusible(s) ont une température de fusion d'au moins 60°C, notamment d'au moins 75°C, de préférence comprise entre 75 et 100°C.

4. Procédé selon l'une des revendications précédentes, ***caractérisé en ce que*** la ou les encres thermofusibles sont insolubles dans l'eau.

5. Procédé selon l'une des revendications précédentes, ***caractérisé en ce que*** la ou les encres thermofusibles résistent à une attaque par de l'hydrogène naissant.

6. Procédé selon l'une des revendications précédentes, ***caractérisé en ce qu'on*** dépose le masque (3) par une technique d'impression par jet d'encre, notamment du type jet d'encre « goutte à la demande » piézo-électrique.

7. Procédé selon l'une des revendications précédentes, ***caractérisé en ce qu'il*** comporte les phases successives suivantes :
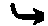 (a) - le dépôt d'un masque (3) comprenant au moins une encre thermofusible sur la couche (2) à graver,
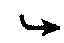 (b) - l'attaque de la couche (2) dans les zones (2') dépourvues du masque (3) par de l'hydrogène naissant,
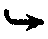 (c) - optionnellement, un traitement de nettoyage du substrat (1) à couche,
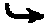 (d) - le retrait du masque (3).

8. Procédé selon la revendication 7, ***caractérisé en ce qu'on*** génère lors de la phase (b) de l'hydrogène naissant en mettant en contact les zones de la couche (2') dépourvues du masque (3) avec du zinc, notamment pulvérulent ou sous forme de couche (4), puis avec une solution à pH acide ou inversement.

9. Procédé selon la revendication 8, ***caractérisé en ce que*** le zinc est pulvérulent (4) et projeté sur la couche (2) en phase solide.

10. Procédé selon la revendication 8, ***caractérisé en ce que*** le zinc est pulvérulent (4) et projeté sur la couche (2) en phase liquide, fluide ou de type aérogel, notamment en suspension dans un ou plusieurs solvants organiques et/ou aqueux (5) éventuellement munis au moins d'additifs modificateurs de rhéologie du type aérosil.

11. Procédé selon la revendication 10, ***caractérisé en ce qu'on*** projette le zinc (4) en suspension dans la phase liquide, fluide ou de type aérogel par une technique de spray ou par sérigraphie.

12. Procédé selon l'une des revendications 8 à 11, ***caractérisé en ce que*** la solution à pH acide comprend au moins un solvant aqueux, alcoolique ou hydroalcoolique et un acide fort du type HCI, et éventuellement des additifs du type surfactants.

13. Procédé selon la revendication 12, ***caractérisé en ce que*** la solution à pH acide comprend en pourcentage massique de 1 à 20% d'acide, notamment de 1 à 10% d'acide.

14. Procédé selon l'une des revendications 8 à 13, ***caractérisé en ce qu'on*** met en contact la solution à pH acide avec la couche à graver (2) par immersion du substrat (1) ou par spray.

15. Procédé selon la revendication 7, ***caractérisé en ce qu'on*** génère lors de la phase (b) de l'hydrogène naissant en mettant en contact les zones de la couche (2') dépourvues du masque (3) avec de l'aluminium, notamment pulvérulent ou sous forme de couche, puis avec une solution à pH alcalin, ou inversement.

16. Procédé selon l'une des revendications 7 à 15, ***caractérisé en ce que*** la phase (c) de nettoyage consiste à rincer la couche (2), par spray ou par immersion du substrat (1), à l'aide d'une solution à base d'eau et/ou de solvants organiques.

17. Procédé selon l'une des revendications 7 à 16, ***caractérisé en ce qu'on*** effectue le retrait du masque (3) par dissolution dans un solvant approprié, notamment un solvant essentiellement organique, ou par traitement aux ultrasons, ou par ramollissement puis pelage par traction mécanique, ou par une lame d'air chaud.

18. Procédé selon l'une des revendications 7 à 16, ***caractérisé en ce qu'on*** effectue le retrait du masque (3) par un traitement thermique, notamment concomitant à un traitement thermique du substrat (1) et/ou de la ou des couches qui le revêtent.

19. Procédé selon l'une des revendications précédentes, ***caractérisé en ce qu'il*** grave des couches à base d'oxyde métallique dopé, notamment des couches à base d'oxyde d'étain dopé au fluor, à l'arsenic ou à l'antimoine, à base d'oxyde d'indium dopé à l'étain ITO.

20. Utilisation du procédé selon l'une des revendications précédentes à la fabrication d'électrodes/éléments conducteurs dans l'industrie verrière, notamment pour des vitrages chauffants, vitrages à antenne, dans l'industrie électronique, notamment pour des écrans émissifs du type écran plat tels que les écrans plasma ou pour les écrans tactiles, dans l'industrie des cellules photovoltaïques.
